(19) Europäisches Patentamt
European Patent Office
Office européen des brevets

(11) **EP 3 324 510 A1**

(12) **EUROPEAN PATENT APPLICATION**

(43) Date of publication:
**23.05.2018 Bulletin 2018/21**

(51) Int Cl.:
*H02J 7/00* (2006.01)     *H02J 7/04* (2006.01)

(21) Application number: **17171266.4**

(22) Date of filing: **16.05.2017**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**MA MD**<br><br>(30) Priority: **18.11.2016 TW 105137887**<br><br>(71) Applicant: **Industrial Technology Research Institute**<br>**Chutung, Hsinchu 31040 (TW)** | (72) Inventors:<br>• **CHENG, Cheng-Hung**<br>  **106 Taipei City (TW)**<br>• **LIU, Yi-Hua**<br>  **302 Zhubei City, Hsinchu County (TW)**<br><br>(74) Representative: **Krauns, Christian**<br>**Wallinger Ricker Schlotter Tostmann**<br>**Patent- und Rechtsanwälte Partnerschaft mbB**<br>**Zweibrückenstraße 5-7**<br>**80331 München (DE)** |

(54) **SMART CHARGING METHOD**

(57) A smart charging method is provided. The smart charging method includes the following steps: A battery is charged under a constant charging current (S110). Whether a measured voltage is higher than a predetermined voltage value is determined (S120). If the measured voltage is higher than the predetermined voltage value, then the constant charging current is increased (S130).

FIG. 5

**Description**

TECHNICAL FIELD

The disclosure relates in general to a smart charging method.

BACKGROUND

In recent years, governments are actively engaged in the development of new energy and new materials to achieve the purpose of saving carbon. Applications such as consumer electronics, electric vehicles, renewable energy, wireless base stations, UPS, emergency lighting, etc., utilize rechargeable batteries to provide effective and stable primary or partial power sources. Several studies are related to the rechargeable battery.

In general, the studies related to the rechargeable battery include the charging method and the material. For extending the battery life and maximizing the cycle of charging efficiency, a suitable charging method of the rechargeable battery should be selected according to the material of the rechargeable battery. Besides, if the charging rate of the battery is too slow, then the applications of this battery are limited. Thus, how to improve the charging rate of the battery is also an important issue.

SUMMARY

The disclosure is directed to a smart charging method.

According to one embodiment, a smart charging method is provided. The smart charging method comprises the following steps: A battery is charged under a constant charging current. Whether a measured voltage of the battery is higher than a predetermined voltage value is determined. The constant charging current is increased if the measured voltage is higher than the predetermined voltage value.

According to another embodiment, a smart charging method is provided. The smart charging method comprises the following steps: A battery is charged under a constant charging current. Whether a measured voltage gradient of the battery is lower than a predetermined voltage gradient is determined. The constant charging current is increased if the measured voltage gradient is lower than the predetermined voltage gradient.

According to an alternative embodiment, a smart charging method is provided. The smart charging method comprises the following steps: A battery is charged under a constant charging current. Whether a measured voltage gradient of the battery is reduced is determined. The constant charging current is increased if the measured voltage gradient is reduced.

BRIEF DESCRIPTION OF THE DRAWINGS

Fig. 1 shows a measured voltage curve of an aluminum ion battery during a charging operation.

Fig. 2 shows a smart charging system according to one embodiment.

Fig. 3 is a flowchart of a smart charging method according to one embodiment.

Fig. 4 is a flowchart of a smart charging method according to another embodiment.

Fig. 5 is a flowchart of a smart charging method according to another embodiment.

Fig. 6 shows a measured voltage curve of another battery during a charging operation.

Fig. 7 is a flowchart of a smart charging method according to another embodiment.

Fig. 8 is a flowchart of a smart charging method according to another embodiment.

Fig. 9 is a flowchart of a smart charging method according to another embodiment.

Fig. 10 is flowchart of a smart charging method according to another embodiment.

Fig. 11 is a flowchart of a smart charging method according to another embodiment.

Fig. 12 is a flowchart of a smart charging method according to another embodiment.

Fig. 13 shows a charging current curve and a measured voltage curve according to the embodiment of Fig. 5.

Fig. 14 shows a charging current curve and a measured voltage curve according to the embodiment of the Fig. 9.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

DETAILED DESCRIPTION

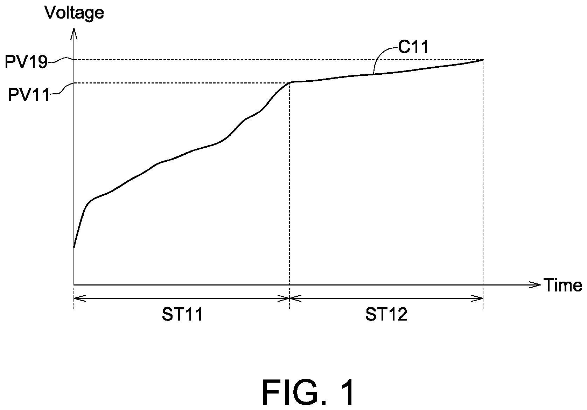

Please refer to Fig. 1, which shows a measured voltage curve C11 of an aluminum ion battery during a charging operation. The charging/discharging reaction of the aluminum ion battery comprises a positive reaction illustrated as the equation (1) and a negative reaction illustrated as the equation (2). The constant current charging operation of the aluminum ion battery comprises a stage ST11 and a stage ST12. In the stage ST11, the reactions of the aluminum ion battery comprise an ion intercalation reaction and an ionic liquid reaction, so the charging rate is high; in the stage ST12, the reactions of the aluminum ion battery comprise the ionic liquid reaction only, so the charging rate is low.

$$4\,Al_2Cl_7^- + 3e^- \leftrightarrow Al + 7\,AlCl_4^- \quad \dots\dots\dots\dots\dots\dots\dots\dots\dots\dots\dots\dots\dots\dots\dots\dots \quad (1)$$

$$C_n + AlCl_4^- \leftrightarrow C_n\big[AlCl_4\big] + e^- \dots\dots\dots\dots\dots\dots\dots\dots\dots\dots\dots\dots\dots\dots \quad (2)$$

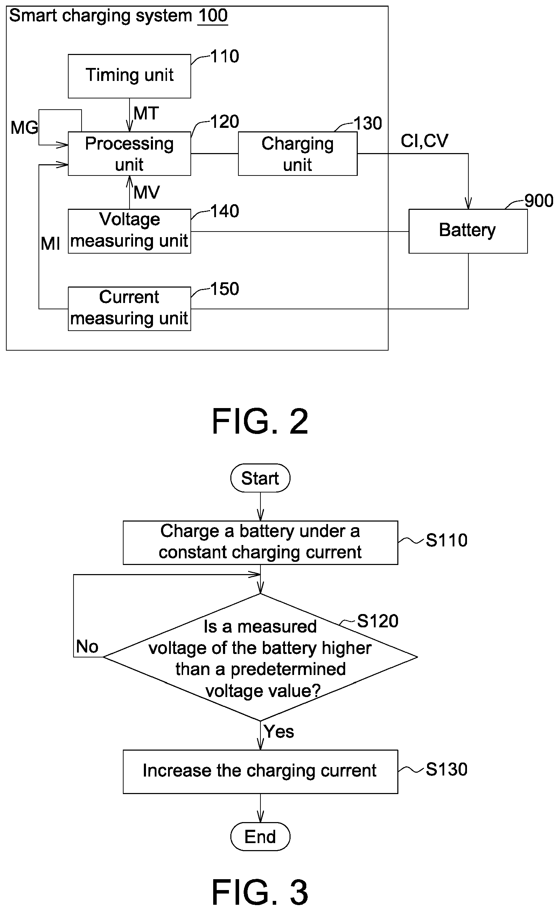

Please refer to Fig. 2, which shows a smart charging system 100 according to one embodiment. The smart charging system 100 can improve the charging rate of a battery 900 via a multi-stage charging method. The smart charging system 100 comprises a timing unit 110, a processing unit 120, a charging unit 130, a voltage measuring unit 140 and a current measuring unit 150. The smart charging system 100 is used for charging the battery 900. The battery 900 has a multi-stage reaction. For example, the battery 900 is the aluminum ion battery described above.
The timing unit 110 is used for counting time. The processing unit 120 is used for performing various determining procedures, various calculating procedures and various controlling procedures. Each of the timing unit 110 and the processing unit 120 may be circuit, a circuit board, a chip or a storage device storing a plurality of program codes. The charging unit 130 is used for charging the battery 900. The voltage measuring unit 140 is used for measuring a measured voltage of the battery 900. The current measuring unit 150 is used for measuring a measured current of the battery 900. Each of the charging unit 130, the voltage measuring unit 140 and the current measuring unit 150 may be a circuit, a circuit board, a chip or a Microelectromechanical Systems (MEMS).
Several embodiments of the smart charging method are illustrated by some flowcharts. Please refer to Fig. 3, which is a flowchart of a smart charging method according to one embodiment. In the step S110, the processing unit 120 controls the charging unit 130 to charge the battery under a constant charging current CI. That is to say, a constant current mode is applied by the processing unit 120.
Next, in the step S120, the voltage measuring unit 140 measures the measured voltage MV of the battery 900, and the processing unit 120 determines whether the measured voltage MV of the battery 900 is higher than a predetermined voltage value PV11 (shown in Fig. 1). The predetermined voltage value PV11 is at the transition point between the stage ST11 and the stage ST12. If the measured voltage MV of the battery 900 is higher than the predetermined voltage value PV11, then the charging operation of the battery 900 enters the stage ST12 from the stage ST11.
If the measured voltage MV is higher than the predetermined voltage value PV11, then the process proceeds to the step S130. In the step S130, the processing unit 120 controls the charging unit 130 to increase the constant charging current CI. In one embodiment, the constant charging current CI may be added to a predetermined increment. For example, the predetermined increment is 0.2 ampere, 0.4 ampere or 0.6 ampere. In another embodiment, the constant charging current CI may be multiplied by a predetermined magnification. For example, the predetermined magnification is 110%, 120% or 130%.
Afterwards, the processing unit 120 controls the charging unit 130 to charge the battery 900 under the constant current mode.

Since the constant charging current CI used in the stage ST12 is increased, the charging rate of the stage ST12 can be improved, and the overall charging time can be reduced.

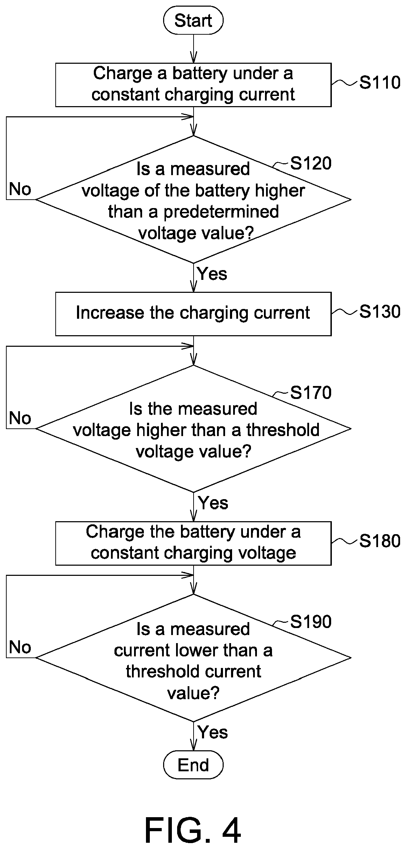

Please refer to Fig. 4, which is a flowchart of a smart charging method according to another embodiment. The smart charging method of the Fig. 4 further comprises the steps S170, S180, S190, and other similarities with the Fig. 3 will not be repeated here. In the step S170, the processing unit 120 determines whether measured voltage MV is higher than a threshold voltage value PV19 (shown in the Fig. 1). The threshold voltage value PV19 is at the end of the constant current mode.

If the measured voltage MV is higher than the threshold voltage value PV19, then the process proceeds to the step S180. In the step S180, the processing unit 120 controls the charging unit 130 to charge the battery 900 under a constant charging voltage CV. That is to say, a constant voltage mode is applied by the processing unit 120.

Then, the current measuring unit 150 measures a measured current MI of the battery 900, and the processing unit 120 determines whether the measured current MI of the battery 900 is lower than a threshold current value (not shown). If the measured current MI is lower than the threshold current value, then the battery 900 is full of electricity and the process is terminated.

By performing the smart charging method of Fig. 4, in the constant current mode, the charging rate can be improved; in the constant voltage mode, the battery 900 can be fully charged.

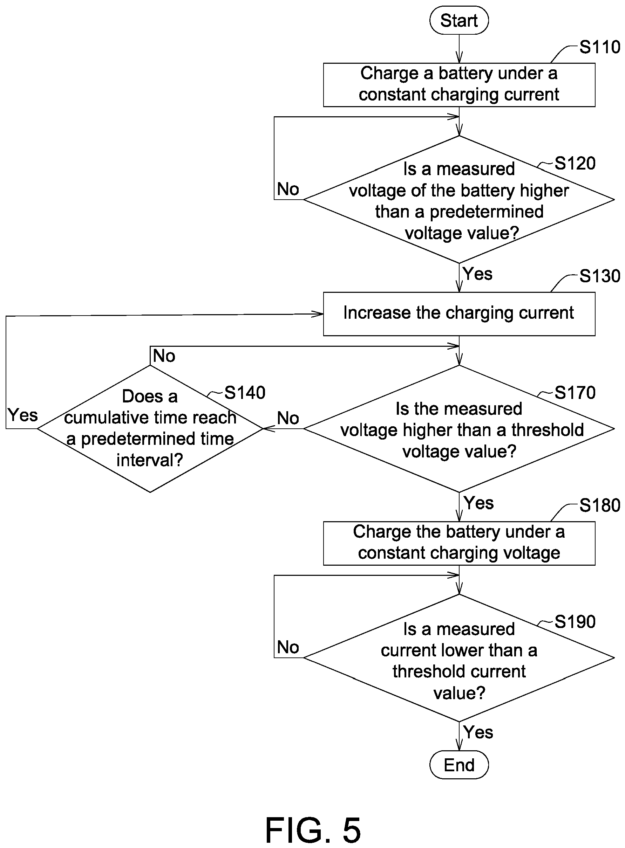

Please refer to Fig. 5, which is a flowchart of a smart charging method according to another embodiment. The smart charging method of the Fig. 5 further comprises the step S140, and other similarities with the Fig. 4 will not be repeated here. In the step S140, the processing unit 120 determines whether a cumulative time MT obtained from the timing unit 110 reaches a predetermined time interval. For example, the predetermined time interval is 10 seconds or 30 seconds. If the cumulative time MT reaches the predetermined time interval, then the process returns to the step S130, for increasing the constant charging current CIagain.

In the embodiment of Fig. 5, when the charging operation of the battery 900 enters the stage ST12, the constant charging current CI is increased every predetermined time interval. If the constant charging current CI is increased by being added to the predetermined increment in the step S130, the constant charging current CI may be 4 ampere, 4.2 ampere, 4.4 ampere, 4.6 ampere, and so on. If the constant charging current CI is increased by being multiplied by the predetermined magnification, the constant charging current CI may be 4 ampere, 4.4 ampere, 4.84 ampere, 5.324 ampere, and so on.

By performing the smart charging method of the Fig. 5, even if the charging rate of the battery 900 in the stage ST12 is reduced with time, the charging rate in the stage ST12 can be improved by repeatedly performing the step S130.

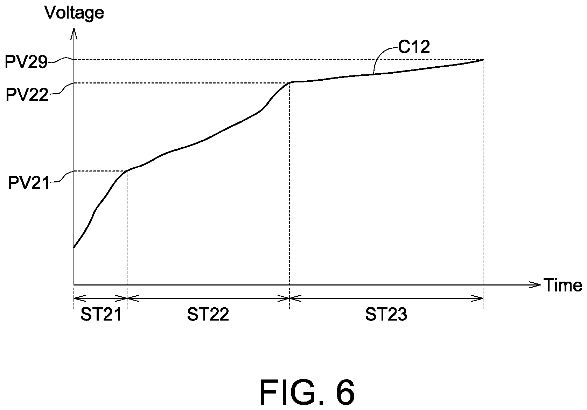

In another embodiment, the charging operation of another battery may have more than two stages. Please refer to Fig. 6, which is another measured voltage curve C12 of another battery during a charging operation. The charging operation of this battery has a stage ST21, a stage ST22 and a stage ST23. The charging rate in the stage ST22 is lower than the charging rate in the stage ST21, and the charging rate in the stage ST23 is lower than the charging rate in the stage ST22. The measured voltage curve of another battery whose charging operation has more than four stages is similar to the measured voltage curve C12 in the Fig. 6, and the similarities will not be repeated here.

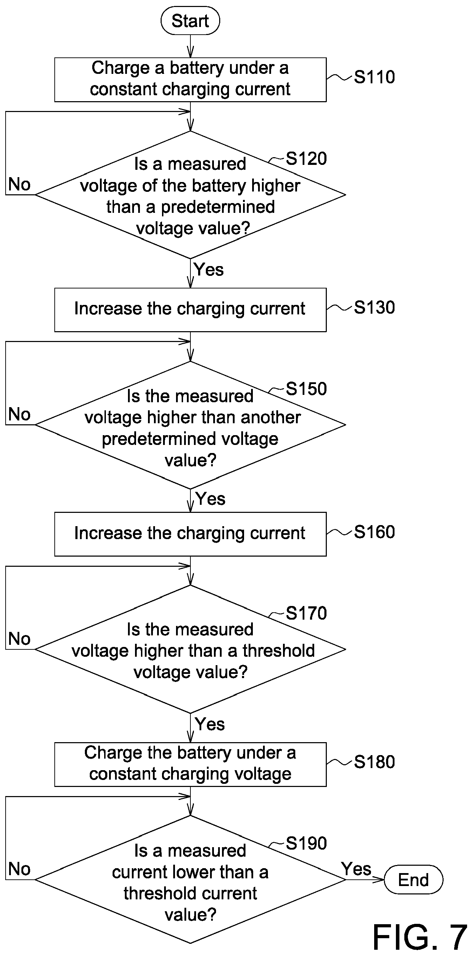

Please refer to Fig. 7, which is a flowchart of a smart charging method according to another embodiment. The smart charging method of the Fig. 7 further comprises the steps S150, S160, and other similarities with the Fig. 4 will not be repeated here. The smart charging method of the Fig. 7 is used for the battery in Fig. 6 whose charging operation has three stages ST21, ST22, ST23.

In the step S120, the processing unit 120 determines whether the measured voltage MV is higher than a predetermined voltage value PV21 (shown in the Fig. 6). If the measured voltage MV is higher than the predetermined voltage value PV21, the process proceeds to the step S130 for increasing the constant charging current CI.

In the step S150, the processing unit 120 determines whether the measured voltage MV is higher than another predetermined voltage value PV22 (shown in the Fig. 6). If the measured voltage MV is higher than the predetermined voltage value PV22, the process proceeds to the step S160, for increasing the constant charging current CI again. The charging operation is kept at the constant current mode. After the determination of the step S170 is that the measured voltage MV is higher than a threshold voltage value PV29 (shown in the Fig. 6), the charging operation enters to the constant voltage mode.

Similarly, for the battery whose charging operation has more than three stages, the smart charging method may comprise more steps of determining whether the measured voltage is higher than another predetermined voltage value, and the constant charging current CI is increased accordingly.

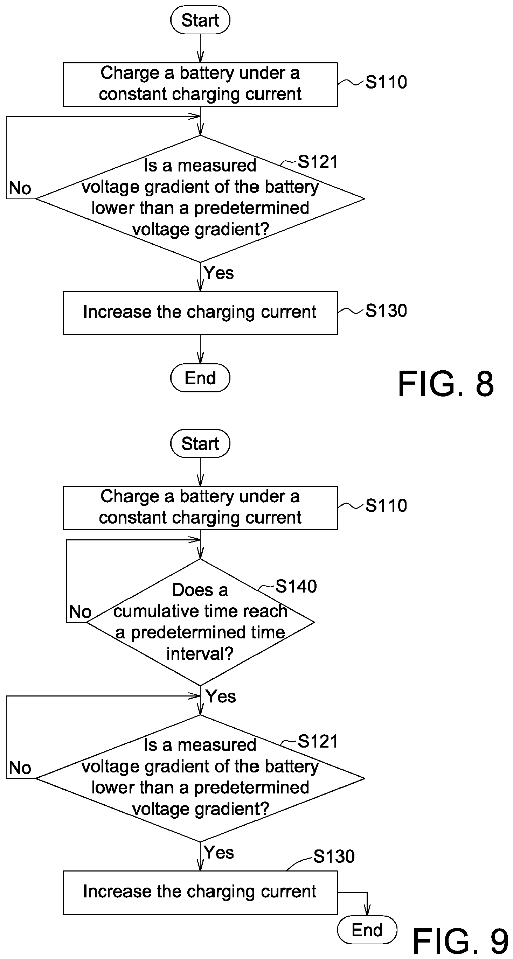

Please refer to Fig. 8, which is a flowchart of a smart charging method according to another embodiment. The difference between the Fig. 3 and the Fig. 8 is in the step S121 of the smart charging method of Fig. 8, and other similarities will not be repeated here. In the step S121, the voltage measuring unit 140 measures the measured voltage MV, and the processing unit 120 calculates a measured voltage gradient MG. The measured voltage gradient MG is the change of the measured voltage MV per unit time. The processing unit 120 determines whether the measured voltage gradient MG of the battery 900 is lower than a predetermined voltage gradient. For example, the predetermined voltage gradient is 0.01 V/min.

If the measured voltage gradient MG is lower than the predetermined voltage gradient, then the charging operation of the battery 900 enters the stage ST12 from the stage ST11 and the process proceeds to the step S130 for increasing the constant charging current CI.

In one embodiment, the battery 900 may decay with time, so the transition point between the stage ST11 and the stage ST12 is shifted and the predetermined voltage value PV11 cannot be known in advance. According to the smart charging method of Fig. 8, after setting the predetermined voltage gradient, the step S121 can be performed without knowing the predetermined voltage value PV11.

Please refer to Fig. 9, which is a flowchart of a smart charging method according to another embodiment. The smart charging method of the Fig. 9 further comprises the step S140, and other similarities with the Fig. 8 will not be repeated here. In the step S140, the processing unit 120 determines whether the cumulative time MT provided from the timing unit 110 reaches the predetermined time interval. For example, the predetermined time interval is 10 seconds or 30 seconds. Whether the measured voltage gradient MG is lower than the predetermined voltage gradient is determined in the step S121 every predetermined time interval. If the measured voltage gradient MG is lower than the predetermined voltage gradient, then the constant charging current CI is increased.

In the embodiment of Fig. 9, the constant charging current CI may be increasing by being added to the predetermined increment, so the constant charging current CI may be 4 ampere, 4.2 ampere, 4.4 ampere, 4.6 ampere, and so on. Or, the constant charging current CI may be increased by being multiplied by the predetermined magnification, so the constant charging current CI may be 4 ampere, 4.4 ampere, 4.84 ampere, 5.324 ampere, and so on.

According to the smart charging method of the Fig. 9, even if the charging rate of the battery 900 is reduced with time, the charging rate can be improved by repeatedly performing the step S121 and the S130.

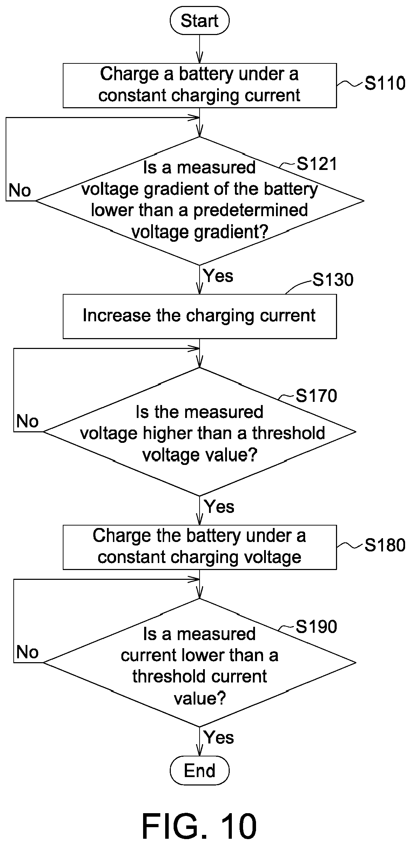

Please refer to Fig. 10, which is a flowchart of a smart charging method according to another embodiment. The smart charging method of Fig. 10 further comprises the step S170, the step S180 and the step S190. The illustrations of the step S170, the step S180 and the step S190 is similar to that of the Fig. 4, and the similarities will not be repeated here. By performing the smart charging method of Fig. 10, in the constant current mode, the charging rate can be improved; in the constant voltage mode, the battery 900 can be fully charged.

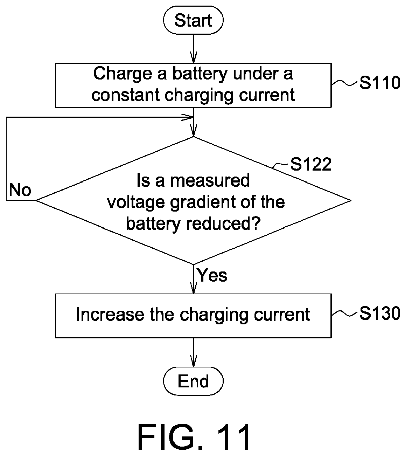

Please refer to Fig. 11, which is a flowchart of a smart charging method according to another embodiment. The difference between the Fig. 8 and the Fig. 11 is in the step S122 of the smart charging method of the Fig. 11, and other similarities will not be repeated here. In the step S122, after the voltage measuring unit 140 measures the measured voltage MV and the processing unit 120 calculates the measured voltage gradient MG, the processing unit 120 determines whether the measured voltage gradient MG of the battery 900 is reduced. If the measured voltage gradient MG of the battery 900 is reduced, then the process proceeds to the step S130 for increasing the constant charging current CI.

In the embodiment of the Fig 11, it is no needed to set the predetermined voltage gradient. Without setting the predetermined voltage gradient, the constant charging current CI can be increased for improving the charging rate when the measured voltage gradient MG is reduced.

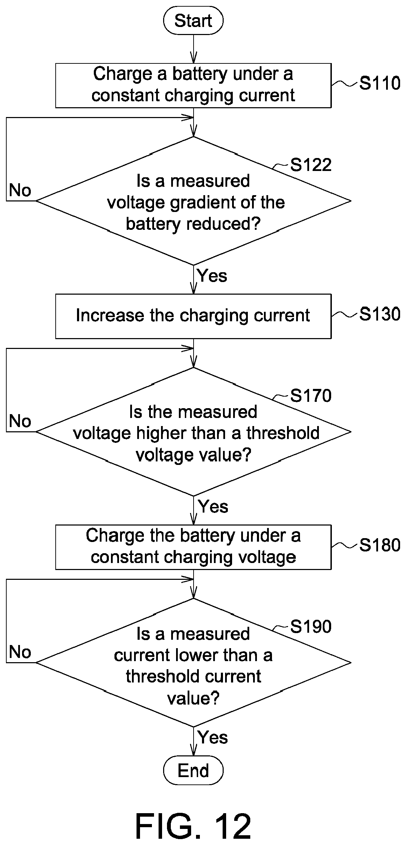

Please refer to Fig. 12, which is a flowchart of a smart charging method according to another embodiment. The difference between the Fig. 11 and the Fig. 12 is in that the smart charging method of the Fig. 12 further comprises the S170, the S180 and the S190. The illustrations of the step S170, the step S180 and the step S190 are similar to that of the Fig. 4, and the similarities will not be repeated here. By performing the smart charging method of Fig. 12, in the constant current mode, the charging rate can be improved; in the constant voltage mode, the battery 900 can be fully charged.

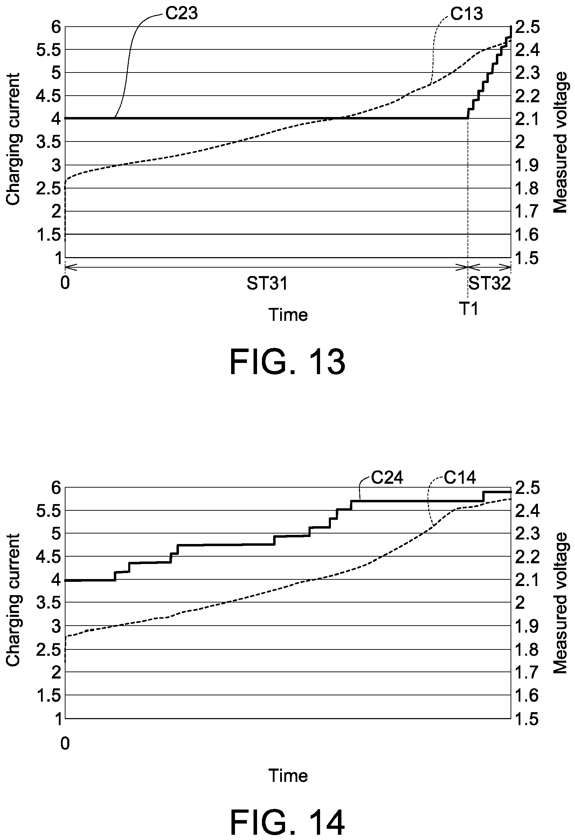

Please refer to Fig. 13, which shows a charging current curve C23 and a measured voltage curve C13 according to the embodiment of Fig. 5. As shown in Fig. 13, after the charging operation of the battery 900 enters the stage ST32 from the stage ST31 at the time point T1, the constant charging current CI is increased every predetermined time interval, so the charging current curve C23 has a ladder-like shape in the stage ST32. The measured voltage curve C13 shows that the charging rate in the stage ST32 can be kept without slowing down. The charging operation of this embodiment spends 41.23 minutes. The charging operation which is applied the constant current mode overall spends 47.35 minutes. The charging operation of this embodiment saves 6.12 minutes (increases 12.93%) comparing to the charging operation which is applied the constant current mode overall.

Please refer to Fig. 14, which shows a charging current curve C24 and a measured voltage curve C14 according to the embodiment of the Fig. 9. As shown in the Fig. 14, when the measured voltage gradient MG is lower than the predetermined voltage gradient, the constant charging current CI is increased. The measured voltage gradient MG may be reduced again and again. The measured voltage gradient MG may be lower than the predetermined voltage gradient at several time points, so the charging current curve C24 has a non-equal length ladder-like shape. The measured voltage curve C14 shows that the charging rate can be kept without slowing down. The charging operation of this embodiment spends 35.48 minutes. The charging operation which is applied the constant current mode overall spends 47.35 minutes. The charging operation of this embodiment saves 11.87 minutes (increases 25.07%) comparing to the charging operation which is applied the constant current mode overall.

It will be apparent to those skilled in the art that various modifications and variations can be made to the disclosed embodiments. It is intended that the specification and examples be considered as exemplary only, with a true scope of the disclosure being indicated by the following claims and their equivalents.

**Claims**

1. A smart charging method, wherein the smart charging method comprises:

   charging a battery (900) under a constant charging current (CI);
   determining whether a measured voltage (MV) of the battery (900) is higher than a predetermined voltage value (PV11, PV21, PV22); and
   increasing the constant charging current (CI) if the measured voltage (MV) is higher than the predetermined voltage value (PV11, PV21, PV22).

2. The smart charging method according to claim 1,

   wherein in the step of increasing the constant charging current, the constant charging current is added to a predetermined increment and/or
   wherein in the step of increasing the constant charging current, the constant charging current is multiplied by a predetermined magnification and/or
   wherein the step of increasing the constant charging current is performed every predetermined time interval.

3. The smart charging method according to claim 1 or 2, further comprising:

   determining whether the measured voltage is higher than a threshold voltage value; and
   charging the battery under a constant charging voltage if the measured voltage is higher than the threshold voltage value.

4. The smart charging method according to anyone of the claims 1 to 3, further comprising:

   determining whether a measured current is lower than a threshold current value; and
   stopping charging the battery if the measured current is lower than the threshold current value.

5. A smart charging method, wherein the smart charging method comprises:

   charging a battery (900) under a constant charging current (CI);
   determining whether a measured voltage gradient (MG) of the battery (900) is lower than a predetermined voltage gradient; and
   increasing the constant charging current (CI) if the measured voltage gradient (MG) is lower than the predetermined voltage gradient.

6. The smart charging method according to claim 5, wherein in the step of increasing the constant charging current, the constant charging current is added to a predetermined increment and/or the constant charging current is multiplied by a predetermined magnification.

7. The smart charging method according to claim 5 or 6, wherein the step of determining whether the measured voltage gradient is lower than the predetermined voltage gradient is performed every predetermined time interval.

8. The smart charging method according to anyone of the claims 5 to 7, further comprising:

   determining whether a measured voltage of the battery is higher than a threshold voltage value; and
   charging the battery under a constant charging voltage if the measured voltage is higher than the threshold voltage value.

9. The smart charging method according to anyone of the claims 5 to 8, further comprising:

determining whether a measured current is lower than a threshold current value; and
stopping charging the battery if the measured current is lower than the threshold current value.

10. A smart charging method, wherein the smart charging method comprises:

charging a battery (900) under a constant charging current (CI);
determining whether a measured voltage gradient (MG) of the battery (900) is reduced; and
increasing the constant charging current (CI) if the measured voltage gradient (MG) is reduced.

11. The smart charging method according to claim 10, wherein in step of increasing the constant charging current, the constant charging current is added to a predetermined increment and/or the constant charging current is multiplied by a predetermined magnification.

12. The smart charging method according to claim 10 or 11, wherein the step of determining whether the measured voltage gradient is reduced is performed every predetermined time interval.

13. The smart charging method according to anyone of the claims 10 to 12, further comprising:

determining whether a measured voltage of the battery is higher than a threshold voltage value; and
charging the battery under a constant charging voltage if the measured voltage is higher than the threshold voltage value.

14. The smart charging method according to anyone of the claims 10 to 13, further comprising:

determining whether a measured current is lower than a threshold current value; and
stopping charging the battery if the measured current is lower than the threshold current value.

15. The smart charging method according to anyone of the claims 1 to 14, wherein the battery is an aluminum ion battery.

FIG. 1

Smart charging system 100

Timing unit ⌐110

MG

↓MT

Processing unit ⌐120

Charging unit ⌐130

CI,CV

↑MV

MI

Voltage measuring unit ⌐140

Current measuring unit ⌐150

Battery ⌐900

# FIG. 2

Start

Charge a battery under a constant charging current ～S110

Is a measured voltage of the battery higher than a predetermined voltage value? ～S120

No

Yes

Increase the charging current ～S130

End

# FIG. 3

```
                    ( Start )
                        │
                        ▼
        ┌───────────────────────────────┐
        │  Charge a battery under a      │ ～S110
        │  constant charging current     │
        └───────────────────────────────┘
                        │
              ┌─────────┘
              │         ▼
              │     ╱─────────────────────╲
              │    ╱   Is a measured        ╲  ～S120
         No   │   ╱  voltage of the battery  ╲
              └──╲   higher than a           ╱
                  ╲  predetermined          ╱
                   ╲ voltage value?        ╱
                    ╲─────────────────────╱
                        │ Yes
                        ▼
        ┌───────────────────────────────┐
        │  Increase the charging current │ ～S130
        └───────────────────────────────┘
                        │
              ┌─────────┘
              │         ▼
              │     ╱─────────────────────╲
              │    ╱   Is the measured      ╲  ～S170
         No   │   ╱  voltage higher than a   ╲
              └──╲   threshold voltage       ╱
                  ╲  value?                 ╱
                   ╲─────────────────────╱
                        │ Yes
                        ▼
        ┌───────────────────────────────┐
        │  Charge the battery under a    │ ～S180
        │  constant charging voltage     │
        └───────────────────────────────┘
                        │
              ┌─────────┘
              │         ▼
              │     ╱─────────────────────╲
              │    ╱   Is a measured        ╲  ～S190
         No   │   ╱  current lower than a    ╲
              └──╲   threshold current       ╱
                  ╲  value?                 ╱
                   ╲─────────────────────╱
                        │ Yes
                        ▼
                    ( End )
```

# FIG. 4

Start

S110

Charge a battery under a
constant charging current

S120

Is a measured
voltage of the battery higher
than a predetermined
voltage value?

No

Yes

S130

Increase the charging current

No

S140

Does a
cumulative time reach
a predetermined time
interval?

Yes

No

S170

Is the measured
voltage higher than a threshold
voltage value?

Yes

S180

Charge the battery under a
constant charging voltage

No

S190

Is a measured
current lower than a
threshold current
value?

Yes

End

FIG. 5

FIG. 6

Start

Charge a battery under a constant charging current — S110

Is a measured voltage of the battery higher than a predetermined voltage value? — S120

No

Yes

Increase the charging current — S130

Is the measured voltage higher than another predetermined voltage value? — S150

No

Yes

Increase the charging current — S160

Is the measured voltage higher than a threshold voltage value? — S170

No

Yes

Charge the battery under a constant charging voltage — S180

Is a measured current lower than a threshold current value? — S190

No

Yes — End

FIG. 7

Start

Charge a battery under a
constant charging current ⟩∽S110

Is a measured ⟩∽S121
voltage gradient of the battery
lower than a predetermined
voltage gradient?

No

Yes

Increase the charging current ⟩∽S130

End

# FIG. 8

Start

Charge a battery under a
constant charging current ⟩∽S110

Does a ⟩∽S140
cumulative time reach
a predetermined time
interval?

No

Yes

Is a measured ⟩∽S121
voltage gradient of the battery
lower than a predetermined
voltage gradient?

No

Yes ∽S130

Increase the charging current

End

# FIG. 9

Start

Charge a battery under a constant charging current — S110

Is a measured voltage gradient of the battery lower than a predetermined voltage gradient? — S121

No

Yes

Increase the charging current — S130

Is the measured voltage higher than a threshold voltage value? — S170

No

Yes

Charge the battery under a constant charging voltage — S180

Is a measured current lower than a threshold current value? — S190

No

Yes

End

FIG. 10

Start

Charge a battery under a
constant charging current — S110

Is a measured
voltage gradient of the
battery reduced? — S122

No

Yes

Increase the charging current — S130

End

FIG. 11

FIG. 12

FIG. 13

FIG. 14

Europäisches
Patentamt
European
Patent Office
Office européen
des brevets

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/084848 A1 (LIU CHAO-HSUAN [TW] ET AL) 27 March 2014 (2014-03-27) * paragraphs [0004], [0005]; figure 1 * | 1-4,15 | INV. H02J7/00 H02J7/04 |
| X | US 2007/108945 A1 (OHASHI TOSHIHARU [JP] ET AL) 17 May 2007 (2007-05-17) * paragraphs [0044] - [0057]; figures 6-8 * | 1-4 | |
| A | TW M 454 634 U (GO-TECH ENERGY CO., LTD) 1 June 2013 (2013-06-01) * the whole document * | 1-15 | |
| A | US 2011/006731 A1 (WANG SHAOLAN [CN] ET AL) 13 January 2011 (2011-01-13) * paragraphs [0034] - [0077]; figure 7 * | 5-15 | |
| | | | TECHNICAL FIELDS SEARCHED (IPC) H02J |

The present search report has been drawn up for all claims

| Place of search | Date of completion of the search | Examiner |
|---|---|---|
| Munich | 11 December 2017 | Lorenzo Feijoo, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 17 1266

This annex lists the patent family members relating to the patent documents cited in the above-mentioned European search report.
The members are as contained in the European Patent Office EDP file on
The European Patent Office is in no way liable for these particulars which are merely given for the purpose of information.

11-12-2017

| Patent document cited in search report | | Publication date | Patent family member(s) | | Publication date |
|---|---|---|---|---|---|
| US 2014084848 | A1 | 27-03-2014 | TW | 201414137 A | 01-04-2014 |
| | | | US | 2014084848 A1 | 27-03-2014 |
| US 2007108945 | A1 | 17-05-2007 | CN | 1979997 A | 13-06-2007 |
| | | | CN | 201029208 Y | 27-02-2008 |
| | | | EP | 1816722 A2 | 08-08-2007 |
| | | | JP | 4222362 B2 | 12-02-2009 |
| | | | JP | 2007143279 A | 07-06-2007 |
| | | | US | 2007108945 A1 | 17-05-2007 |
| TW M454634 | U | 01-06-2013 | NONE | | |
| US 2011006731 | A1 | 13-01-2011 | NONE | | |

EPO FORM P0459

For more details about this annex : see Official Journal of the European Patent Office, No. 12/82